# EUROPEAN PATENT APPLICATION

(11) **EP 1 458 014 A1**
(43) Date of publication of application: **15.09.2004**
(21) Application number: 04250644.4
(22) Date of filing: 06.02.2004
(51) Int. Cl.: H01L 21/00

(54) **Daf tape adhering apparatus and method**

(30) Priority: 13.03.2003 JP 2003068253
(71) Applicant: TOKYO SEIMITSU CO.,LTD., Mitaka-shi Tokyo (JP)
(72) Inventor: Kobayashi, Kazuo, c/o Tokyo Seimitsu Co. Ltd., Mitaka-shi, Tokyo (JP)
(74) Representative: Rackham, Stephen Neil

(57) **Abstract**

A method for adhering a DAF tape, and a DAF tape adhering apparatus using the method, are provided. A wafer (41) is secured on a stage (40) in a lower kiln (32), a DAF tape (12) is held by the lower kiln (32) and an upper kiln (31) is opposed to the lower kiln (32), and further, the pressure in the upper kiln (31) is made higher than the pressure in the lower kiln (32) to cause the DAF tape to bulge and to adhere to the wafer (42). The stage (40) can be movable toward the DAF tape (12). Further, an air supply part (50) may be provided in the upper kiln (31). The pressure in the upper kiln may be made higher than the pressure in the lower kiln by supplying air from the air supplying part (50). A vacuum source may be connected to the lower kiln (32) to reduce the pressure in the lower kiln. The formation of wrinkles in the DAF tape (12) and the trapping of air bubbles under the DAF tape (12) can be prevented.

## Description

The present invention relates to a DAF Tape adhering apparatus for adhering a DAF tape, that is, a Die Attach Film tape.

To manufacture a die or a chip, a dicing film (dicing sheet) is adhered to a back surface of a wafer having semiconductor devices formed thereon and, thereafter, the wafer is subject to dicing using a dicing apparatus, and the dicing film is entirely expanded. After that, each semiconductor device is picked up and die-bonded to another substrate.

In order to carry out die bonding, it is necessary to apply an adhesive to a bottom surface of a die. As an adhesive, conventionally, a liquid die attach agent is mainly used. However, recently, because the die itself is made thin, by a back grinder, if a liquid die attach agent is used, the die attach agent may rise along a side wall of the die and reach the semiconductor device. Recently, in order to avoid such a problem, a sheet-type die attach film tape (hereinafter, referred to as "DAF tape") is adhered to a die, instead of using the liquid die attach agent.

Various adhering methods for adhering a sheet-type tape to a wafer have been disclosed. Among them, in a known method for adhering a protection tape to a wafer surface to protect the latter, the protection tape and a wafer are arranged obliquely each other; the protection tape and the wafer are overlapped partly at only one end using a roller; and a space between the protection tape and the wafer is evacuated. In this method, no wrinkles occur on the protection tape, and no air bubbles are produced between the protection tape and the wafer (see, for example, Kokai (Japanese Unexamined Patent Publication) No. 2001-148412).

However, above publication discloses a method and a device for adhering a protection tape for protecting a semiconductor device on a surface of a wafer, and the protection tape is different from a DAF tape. Namely, the protection tape for protecting a semiconductor device is preferably relatively thick (for example, 100 µm in thickness), whereas a DAF tape used as an adhesive is preferably relatively thin (for example, 25 µm in thickness). Accordingly, when such a thin DAF tape is superimposed on the wafer at one end thereof, a physical force tends to be exerted on the DAF tape. Also, as the DAF tape is relatively thin, it is relatively difficult to adhere the tape. Accordingly, compared to the adhering of a protection tape, it is more likely that a wrinkle is formed in the DAF tape or an air bubble is produced between the DAF tape and the wafer, in the course of adhering of a DAF tape.

As described above, because the DAF tape serves as an adhesive, it is preferable that the DAF tape itself be thin. Especially, a DAF tape tends to be thinner due to recent technological innovations. Consequently, the risk of forming a wrinkle and/or producing an air bubble, by exertion of a physical force, has been further increased.

The present invention has been completed in view of the above-mentioned drawbacks. The object of the invention is to provide a DAF tape adhering apparatus wherein a DAF tape can be adhered without forming a wrinkle on the DAF tape and/or producing an air bubble in the DAF tape.

In order to attain the above-mentioned object, according to one aspect of the invention, a DAF tape adhering apparatus comprising, a wafer secured on a table, a DAF tape arranged above the wafer, a substantially annular holder for holding the DAF tape from both sides, and a gas supplier for supplying gas toward the DAF tape in the holder, wherein the gas is discharged toward the DAF tape to swell the DAF tape in the holder toward the wafer, to thereby adhere the DAF tape to the wafer, is provided.

With this aspect, as the DAF tape is swelled and adhered onto the wafer, no formation of a wrinkle on, and/or production of an air bubble under, the DAF tape occurs.

According to another aspect, a DAF adhering apparatus comprising, an upper kiln, a lower kiln opposed to the upper kiln, a DAF tape held by the upper kiln and the lower kiln, and a wafer secured on a table in the lower kiln, wherein a pressure in the upper kiln is made relatively higher than the pressure in the lower kiln to swell the DAF tape, to thereby adhere the DAT tape on the wafer, is provided.

With this aspect, the DAF tape is swelled and adhered onto the wafer and, hence, no formation of a wrinkles and/or no production of an air bubbles occurs. This aspect includes alternatives that only the upper kiln is pressurized, that only the pressure in the lower kiln is reduced, and that the upper kiln is pressurized while the pressure in the lower kiln is reduced.

According to still another aspect of the invention, a method for adhering a DAF tape comprising securing a wafer on a table, arranging a DAF tape above the wafer, holding the DAF tape from both sides by a substantially annular holder, and supplying gas from a gas supplier toward the DAF tape to swell the DAF tape toward the wafer, to thereby adhere the DAF tape on the wafer, is provided.

Namely, according to this aspect of the invention, as the DAF tape is swelled and adhered onto the wafer, no wrinkle is formed and/or no air bubble is produced.

According to yet another aspect, a method for adhering a DAF tape comprising, securing a wafer on a stage in a lower kiln, holding a DAF tape by the lower kiln and an upper kiln opposed to the lower kiln, making the pressure in the upper kiln relatively higher than the pressure in the lower kiln to swell the DAF tape, to thereby adhere the DAF tape on the wafer, is provided.

Namely, according to this aspect, as the DAF tape is swelled and adhered onto the wafer, it is possible to prevent formation of a wrinkle and/or production of an air bubble. This aspect includes alternatives that only the upper kiln is pressurized, that only the pressure in the lower kiln is reduced, and that the upper kiln is pressurized while the pressure in the lower kiln is reduced.

### Brief Description of the Drawings

Fig. 1 shows a side view of a DAF tape adhering apparatus according to a typical embodiment of the present invention.
Fig. 2a is a side view showing a swelling operation of a DAF tape in a DAF tape adhering apparatus according to a typical embodiment of the present invention.
Fig. 2b is a side view showing a swelling operation of a DAF tape in a DAF tape adhering apparatus according to a typical embodiment of the present invention.
Fig. 3a is a side view showing an adhering operation of a DAF tape in a DAF tape adhering apparatus according to a typical embodiment of the present invention.
Fig. 3b is a side view showing an adhering operation of a DAF tape in a DAF tape adhering apparatus according to a typical embodiment of the present invention.
Fig. 3c is a side view showing an adhering operation of a DAF tape in a DAF tape adhering apparatus according to a typical embodiment of the present invention.
Fig. 4a is a partial plan view of a DAF tape adhering apparatus according to another embodiment of the present invention.
Fig. 4b is a side view of a DAF tape adhering apparatus according to another embodiment of the present invention.

### Description of the Preferred Embodiments

Embodiments of the present invention will be explained below with reference to the attached drawings. In the drawings, like reference numerals are assigned to the same components.

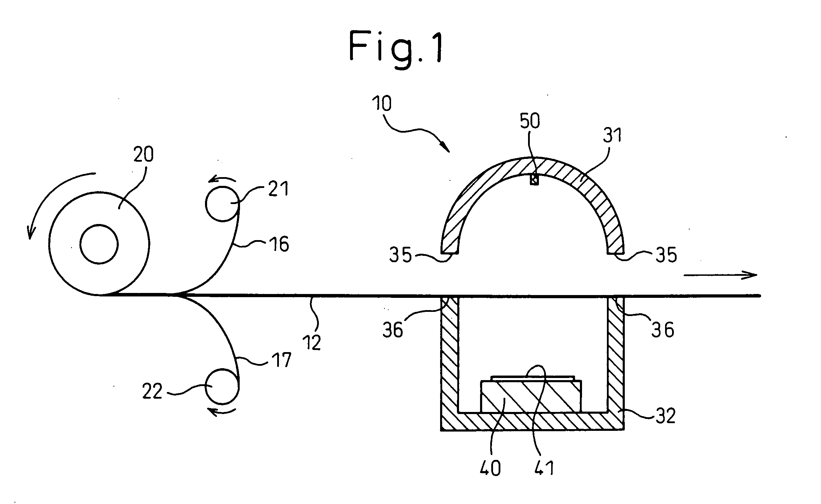

Fig. 1 shows a side view of a DAF tape adhering apparatus according to a typical embodiment of the present invention. Usually, a DAF tape 12 is in the form of a roll 20, and release backing papers 16 and 17 are adhered to both sides of the DAF tape 12. When the DAF tape is used, the release backing papers 16 and 17 on both sides of the tape are released and wound around other rollers 21 and 22, as shown in Fig. 1.

As shown in Fig. 1, a DAF tape adhering apparatus 10 comprises an upper kiln 31 and a lower kiln 32, which are arranged with the inlets of the kilns 31 and 32 opposed to each other. A stage 40 for firmly holding a wafer 41 whose surface having semiconductor devices is oriented downward, is arranged within the lower kiln 31. The inlets of the upper kiln 31 and the lower kiln 32 are substantially identical in shape so that, in use, the upper kiln 31 and the lower kiln 32 can hold the DAF tape 12 therebetween in an air tight fashion. Also, a cross-sectional shape of the upper kiln 31 and the lower kiln 32 is almost the same as, or larger than that of the wafer 41 described below. Accordingly, the length of the upper kiln 31 and the lower kiln 32 in the width direction of the DAF tape is smaller than the width of the DAF tape 12.

The stage 40 is arranged substantially at the center of the lower kiln 32. A common vacuum suction stage or other stage capable of holding a wafer due to vacuum suction can be used as the stage 40. It is preferable that the stage can be elevated and lowered, as will be described below. Further, the upper kiln 31 is provided on its inner wall with a gas supplying part 50.

When used, the wafer 41 to which the DAF tape is to be adhered is fixed on the stage 40 in the lower kiln 32 of the DAF tape adhering apparatus 10, so that the surface of the wafer having the semiconductor devices formed thereon is in contact with the surface of the stage. In the present invention, it is assumed that the wafer 41 has, on a front surface, semiconductor devices and is ground at a back surface by a back grinder. However, a wafer whose back surface is not ground is included in the scope of the present invention.

Next, the roll 20 is driven by a motor (not shown) to feed the DAF tape 12. The release backing papers 16 and 17 of the DAF tape 12 are wound around the rollers 21 and 22, and the tape is carried in the DAF tape adhering apparatus 10. As shown in Fig. 1, the DAF tape 12 is arranged in parallel with the stage 40 between the upper kiln 31 and the lower kiln 32.

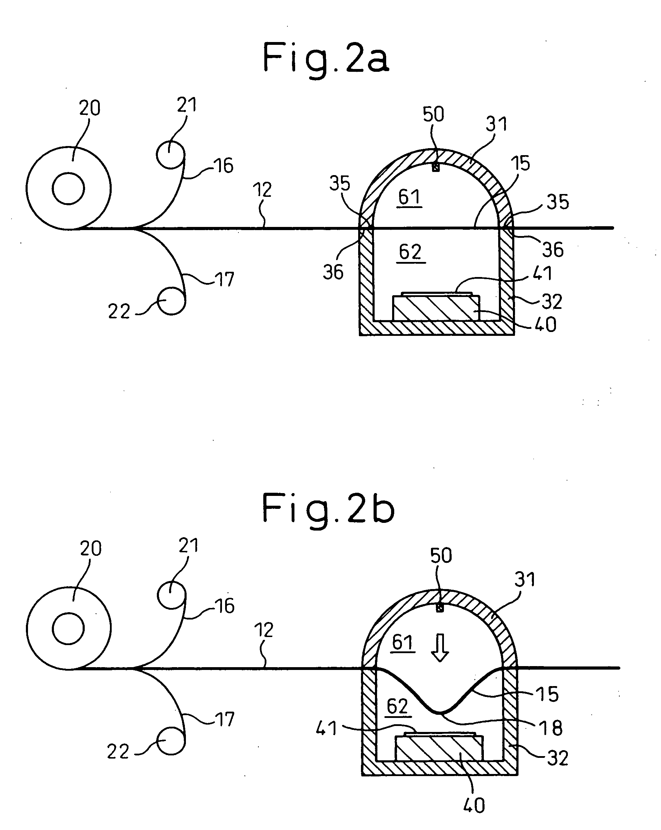

Fig. 2a and Fig. 2b show side views showing the swelling operations of the DAF tape according to a typical embodiment of the DAF adhering apparatus of the present invention. In the drawings, the swelling of the DAF tape is exaggerated for clarity. After the DAF tape 12 is arranged between the upper kiln 31 and the lower kiln 32, the upper kiln 31 and the lower kiln 32 are engaged as shown in Fig. 2a. The DAF tape 12 is sandwiched between a rim 35 of the upper kiln 31 and a rim 36 of the lower kiln 32, and the upper kiln 31 and the lower kiln 32 are sealed through the DAF tape 12. Accordingly, isolated upper and lower compartments 61 and 62 are formed in the upper kiln 31 and the lower kiln 32, respectively.

Then, as shown in Fig. 2b, gas is supplied from the gas supplying part 50 in the upper kiln 31. The gas supplied from the gas supplying part 30 is, for example, air or nitrogen or the like. Consequently, the DAF tape portion held by the upper kiln 31 and the lower kiln 32 in the DAF tape adhering apparatus 10 (hereinbelow, referred to as "DAF tape 15") is swelled toward the wafer 41. As mentioned above, the stage 40 is located substantially at the center of the lower kiln 32. Thus, the center 18 of the swelled part of the DAF tape 15 is located substantially directly above the center of the wafer 41.

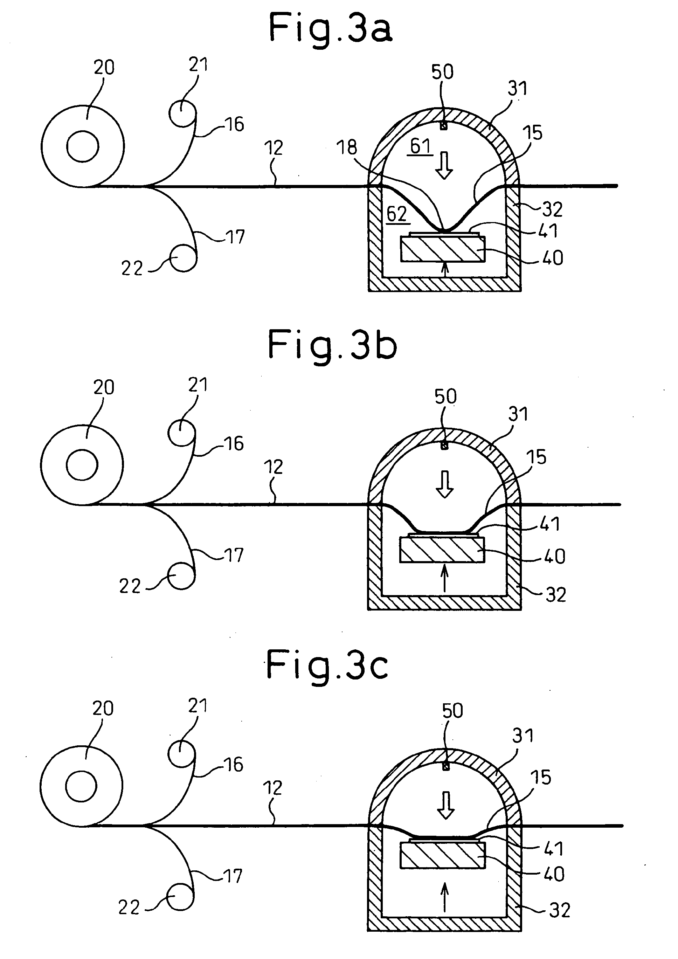

Figs. 3a to 3c show side views of the adhering operation in a typical embodiment of the DAF tape adhering apparatus. As shown in Fig. 3a, while the DAF tape 15 is swelled toward the wafer 41, the stage 40 is moved upward by elevating and lowering means (not shown). Consequently, the center 18 of the swelled DAF tape 15 contacts substantially the center of the wafer 41, and is adhered thereto at this position. As shown in Fig. 3b, further upward movement of the stage 40 causes the DAF tape 15 to be gradually adhered to the wafer 41 from the center in the radially outwardly direction of the wafer. As shown in Fig. 3c, when the stage 40 is moved further upward, the DAF tape 15 is adhered over the almost entire surface of the wafer 41. Thereafter, the gas supply from the gas supplying part 50 is stopped and the upper kiln 31 and the lower kiln 32 are disengaged and the DAF tape 15 around the wafer 41 is cut by a cutter (not shown).

As mentioned above, when adhering the DAF tape, the DAF tape is swelled to adhere to the wafer at the center of the swelled part. Therefor, unlike the prior art, in the present invention no wrinkle is formed in the DAF tape and/or no air bubble is produced under the DAF tape. As a matter of course, it is possible to pressurize the upper kiln 31 by means of a method other than the use of the gas supplying part 50. Alternatively, it is also possible to move both the upper kiln 31 and the lower kiln 32 together toward the wafer, after swelling the DAF tape. Also, it is apparent that an arrangement in which the side surface of the stage 40 comes into contact with the inside wall of the lower kiln 32 so as to hermetically slide the stage 40 along the inside wall of the lower kiln 32, and an arrangement in which the upper kiln 31 and the lower kiln 32 have shapes different from those in the illustrated embodiments are included within the scope of the present invention.

Alternatively, a vacuum source (not shown) can be connected to the lower kiln 32 to reduce the pressure of and/or evacuate the lower compartment 62 when used. In this alternative, it is possible to certainly prevent air bubbles from being produced in the DAF tape.

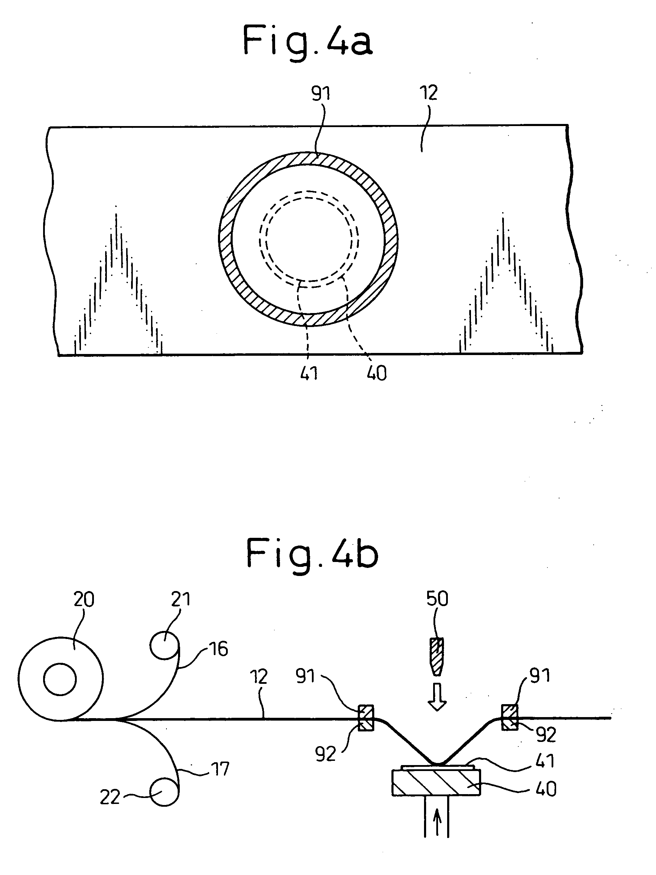

Fig. 4a and Fig. 4b show a partial top view and a side view of the DAF adhering apparatus according to another embodiment. As shown in Fig. 4a and Fig. 4b, substantially annular upper and lower holders 91 and 92 for holding the DAF tape 12 from both sides are provided, instead of the upper kiln 31 and the lower kiln 32. As shown in Fig. 4a, the upper holder 91 is smaller than the width of the DAF tape 12. After holding the DAF tape 12 from both sides by the holders 91 and 92, the DAF tape 12 is located above the wafer 41. As shown in Fig. 4b, a predetermined distance is provided between the DAF tape 12 and the wafer 41. Gas is supplied from the gas supplying part 50 toward the DAF tape 12 from above the DAF tape 12. It is preferable that the gas be discharged toward the center of the DAF tape 12 held by the annular holders 91 and 92. Consequently, as mentioned above, the DAF tape 12 is swelled. Finally, the stage 50 on which the wafer 41 is secured is moved toward the DAF tape 12 to thereby adhere the DAF tape 12 to the wafer 41. In this embodiment, formation of wrinkles in the DAF tape and/or production of air bubbles under the DAF tape can be prevented, unlike the prior art.

In the above-mentioned two embodiments, the stage is moved after the DAF tape is swelled. However, an embodiment in which the DAF tape is adhered only by swelling the DAF tape without moving the stage is included within the scope of the present invention. As a matter of course, an arrangement in which the DAF tape adhering apparatus is integrally built with a back grinder (not shown) and the DAF tape is adhered after back surface of the wafer is ground by the back grinder, is also within the scope of the present invention.

According to the present invention, no wrinkle is formed in, and/or no air bubble is produced under, the DAF tape in any embodiments of the invention.

## Claims

1. A DAF tape adhering apparatus comprising,
a wafer secured on a table,
a DAF tape arranged above the wafer,
a substantially annular holder for holding the DAF tape from both sides, and
a gas supplier for supplying gas toward the DAF tape in the holder,
wherein the gas is discharged toward the DAF tape to swell the DAF tape in the holder toward the wafer, to thereby adhere the DAF tape to the wafer.

2. A DAF tape adhering apparatus according to claim 1, wherein the tape is movable toward the DAF tape.

3. A DAF adhering apparatus comprising,
an upper kiln,
a lower kiln opposed to the upper kiln,
a DAF tape held by the upper kiln and the lower kiln, and
a wafer secured on a table in the lower kiln,
wherein a pressure in the upper kiln is made relatively higher than the pressure in the lower kiln to swell the DAF tape, to thereby adhere the DAT tape on the wafer.

4. A DAF tape adhering apparatus according to claim 3, wherein the table is movable toward the DAF tape.

5. A DAF tape adhering apparatus according to claim 3 or 4, further comprising a gas supplier provided in the upper kiln, wherein gas is supplied by the gas supplier into the upper kiln to make the pressure in the upper kiln higher than the pressure in the lower kiln.

6. A DAF tape adhering apparatus according to claim 3, further comprising a vacuum source connected to the lower kiln, so that the pressure in the lower kiln is reduced and/or the lower kiln is evacuated to a vacuum.

7. A method for adhering a DAF tape comprising,
securing a wafer on a table,
arranging a DAF tape above the wafer,
holding the DAF tape from both sides by a substantially annular holder, and
supplying gas from a gas supplier toward the DAF tape to swell the DAF tape toward the wafer, to thereby adhere the DAF tape on the wafer.

8. A method for adhering a DAF tape according to claim 7, wherein the table is movable toward the DAF tape.

9. A method for adhering a DAF tape comprising,
securing a wafer on a stage in a lower kiln,
holding a DAF tape by the lower kiln and an upper kiln opposed to the lower kiln,
making the pressure in the upper kiln relatively higher than the pressure in the lower kiln to swell the DAF tape, to thereby adhere the DAF tape on the wafer.

10. A method for adhering a DAF tape according to claim 9, wherein the table is movable toward the DAF tape.

11. A method for adhering a DAF tape according to claim 9 or 10, further comprising supplying gas in the upper kiln by a gas supplier provided in the upper kiln, to thereby make the pressure in the upper kiln higher than the pressure in the lower kiln.

12. A method for adhering a DAF tape according to claim 9, further comprising reducing the pressure in the lower kiln and/or evacuating the lower kiln to a vacuum, by a vacuum source connected to the lower kiln.
